# EUROPEAN PATENT APPLICATION

(11) **EP 4 807 991 A1**
(43) Date of publication of application: **16.09.2026**
(21) Application number: 26163912.4
(22) Date of filing: 11.03.2026
(51) Int. Cl.: H03K 17/08

(54) **SYSTEMS AND METHODS FOR CONTROL OF POWER SWITCHING DEVICES**

(30) Priority: 13.03.2025 US 202519078893
(71) Applicant: GE Aviation Systems Limited, Bishops Cleeve Cheltenham Gloucestershire GL52 8SF (GB)
(72) Inventor: ROPER, Simon Edward, Cheltenham, GL52 8SF (GB); ATKINS, Joseph John, Cheltenham, GL52 8SF (GB); HANDY, Peter James, Cheltenham, GL52 8SF (GB)
(74) Representative: Openshaw & Co.

(57) **Abstract**

A system (400) and method (600) for controlling power switching devices are described herein. In some approaches, a system (400) for modelling a temperature rise within a transistor (404) includes a measurement circuit (408), a power calculation circuit (410), a thermal modeling circuit (412) and a control circuit (414). The measurement circuit (408) is configured to measure a voltage (V_{ds}) across the transistor (404) and a current (I_{ds}) passing through the transistor (404). The power calculation circuit (410) is configured to multiply the measured current (I_{ds}) and the measured voltage (V_{ds}) to generate a signal representing a power dissipated within the transistor (404). The thermal modeling circuit (412) is configured to generate an output signal indicative of a die temperature rise in the transistor (404) over a predetermined period and the control circuit (414) is configured to output a trip signal (440) to turn off the transistor (404) in response to determining that the die temperature rise is greater than the predetermined threshold.

## Description

### TECHNICAL FIELD

These teachings relate generally to power switching devices and more particularly to controlling power switching devices.

### BACKGROUND

Solid state power controllers (SSPC) are used in many modern vehicle or aircraft applications. For example, these SSPCS can be used in aircraft to manage and switch current, voltage, and power between a voltage source and aircraft systems or components. Newer electrical systems may use higher voltages and currents, which may increase the likelihood of damage from overload and abnormal current conditions, reliability issues, and poor power quality. Accordingly, a system and method to prevent damage and improve reliability may be desirable.

### BRIEF DESCRIPTION OF DRAWINGS

Various needs are at least partially met through provision of the systems and methods for control of power switching devices described in the following detailed description, particularly when studied in conjunction with the drawings. A full and enabling disclosure of the aspects of the present description, including the best mode thereof, directed to one of ordinary skill in the art, is set forth in the specification, which refers to the appended figures, in which:
FIG. 1 is a schematic diagram of a protection system in accordance with various embodiments of these teachings;
FIG 2A is a graph of current versus time in accordance with various embodiments of these teachings;
FIG 2B is a graph of current versus time in accordance with various embodiments of these teachings;
FIG. 3 is a schematic diagram of a protection system in accordance with various embodiments of these teachings;
FIG. 4 is a schematic diagram of a protection system in accordance with various embodiments of these teachings;
FIG. 5 shows a graph illustrating the power calculation of FIG. 4 in accordance with various embodiments of these teachings; and
FIG. 6 is a flow diagram for a method in accordance with various embodiments of these teachings.

Elements in the figures are illustrated for simplicity and clarity and have not necessarily been drawn to scale. For example, the dimensions and/or relative positioning of some of the elements in the figures may be exaggerated relative to other elements to help to improve understanding of various embodiments of the present teachings. Also, common but well-understood elements that are useful or necessary in a commercially feasible embodiment are often not depicted in order to facilitate a less obstructed view of these various embodiments of the present teachings. Certain actions and/or steps may be described or depicted in a particular order of occurrence while those skilled in the art will understand that such specificity with respect to sequence is not actually required.

### DETAILED DESCRIPTION

The systems and methods to control power switching devices described herein provide approaches for hardware systems that measure or monitor a temperature rise in a transistor to protect the transistor from thermal stress and operation outside of its specification. More specifically, the systems and methods described herein implement operating area protection using a multiplier and a resistor-capacitor (RC) filter. The approaches described herein are advantageous for high-voltage, high-current applications, such as for aircraft applications.

Traditionally, a transistor includes a defined operating area that outlines the maximum power dissipation, current, and voltage under which the transistor may operate. Typically, a solid state power controller (SSPC) may implement a fast trip design. In such approaches, the allowable current is permitted to exceed a nominal rating several times until a threshold is surpassed. If the threshold is not met, due to a partial overcurrent events, or until the threshold is reached, the switching device may experience considerable thermal stress, which may impact reliability.

Accordingly, the hardware operating area protection as described herein is independent of system voltage rate and therefore scales to high voltage distribution without the significant costs or additional power dissipation. Additionally, it protects against obsolescence, a change in the FET due to part availability can be resolved purely in hardware.

In one embodiment, a system for modelling a temperature rise within a transistor includes a measurement circuit configured to measure a voltage across the transistor and a current passing through the transistor. A power calculation circuit determines the power dissipated within the transistor. The dissipated power within the transistor is used to model a die temperature rise in the transistor and a control unit is configured to output a trip signal to turn off the transistor when the die temperature rise exceeds a predetermined threshold.

The terms and expressions used herein have the ordinary technical meaning as is accorded to such terms and expressions by persons skilled in the technical field as set forth above except where different specific meanings have otherwise been set forth herein. The word "or" when used herein shall be interpreted as having a disjunctive construction rather than a conjunctive construction unless otherwise specifically indicated. The terms "coupled," "fixed," "attached to," and the like refer to both direct coupling, fixing, or attaching, as well as indirect coupling, fixing, or attaching through one or more intermediate components or features, unless otherwise specified herein.

The singular forms "a", "an", and "the" include plural references unless the context clearly dictates otherwise.

As used herein, the term "off" refers to a reduction to a level considered as a leakage current of the transistor.

As used herein, the term "temperature" refers to a thermal state of the die in the transistor. For example, temperature may include, but is not limited to, kinetic energy, thermal energy, heat, or any form of thermal transfer or thermal activity.

As used herein, the term "temperature" refers to a thermal state of the die in the transistor. For example, temperature may include, but is not limited to, kinetic energy, thermal energy, heat, or any form of thermal transfer or thermal activity. Approximating language, as used herein throughout the specification and claims, is applied to modify any quantitative representation that could permissibly vary without resulting in a change in the basic function to which it is related. Accordingly, a value modified by a term or terms such as "about", "approximately", and "substantially", are not to be limited to the precise value specified. In at least some instances, the approximating language may correspond to the precision of an instrument for measuring the value, or the precision of the methods or machines for constructing or manufacturing the components and/or systems. For example, the approximating language may refer to being within a 10 percent margin.

The foregoing and other benefits may become clearer upon making a thorough review and study of the following detailed description.

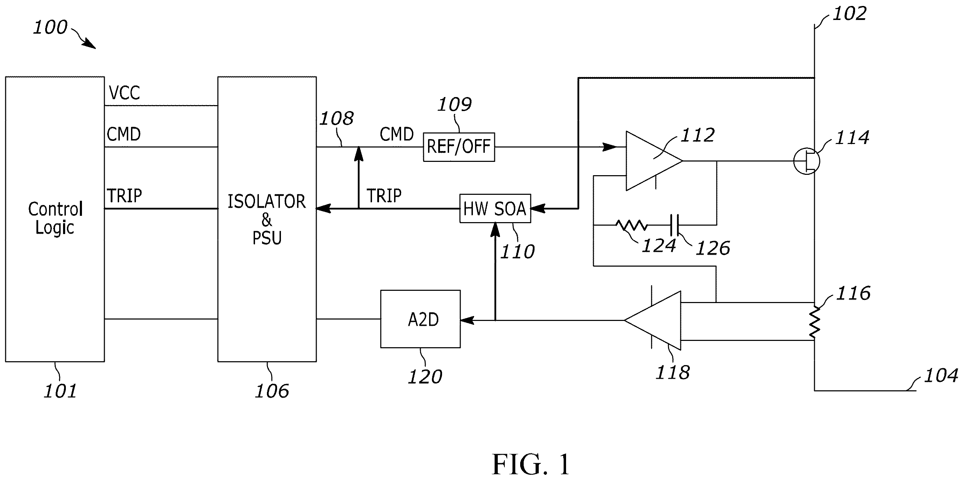

Referring to FIG. 1, a schematic diagram of a solid state power controller (SSPC) 100 with linear mode and hardware operating area protection in accordance with various embodiments is provided. The SSPC 100 is connected to or implemented in an application having the SSPC 100, and in particular, the transistor 114 connected between a voltage source 102 and a load 104. The SSPC 100 includes or has a control logic 101 and isolator and power supply unit 106 to provide a power supply to the transistor 114. The isolator and power supply unit 106 transmits an ON/OFF signal 108 to the transistor 114 and appropriate power rails to allow the transistor to be fully turned on.

The SSPC 100 further includes an integrator 112 with one or more resistors 124 and capacitors 126, a current sense resistor 116, a sense amplifier 118, and an analog to digital converter (ADC) 120. The current sense resistor 116 provides a measure of the current through the transistor 114. The sense amplifier 118 amplifies the signal from the current sense resistor 116 and the analogue to digital converter (ADC) 120 converts this signal to a digital signal. The isolator and power supply unit 106 may transmit the ON/OFF signal 108 to the transistor 114 based on the digital signal received from the control logic 101.

In one form, the SSPC 100 may be operated in linear mode. The linear mode manages inrush current and protects the SSPC 100 from stress when closing into high capacitive loads and avoids nuisance tripping from or other transients, such as lightning. For example, in normal operation, the control parts of the schematic (such as, for example, the control logic 101, the isolator and power supply unit 106, the ON/OFF signal 108, and integrator 112) operate in conjunction to increase the transistor 114 gate voltage (V_{GS}) to turn on the transistor 114 and minimize the transistor 114 resistance (R_{DS(ON)}), and in linear mode the feedback loop which includes the one or more resistors 124 and the one or more capacitors 126 decrease the transistor 114 gate voltage (V_{GS}), which increases the transistor 114 resistance (R_{DS(ON)}). The increase in the transistor 114 resistance (R_{DS(ON)}) manages inrush current. More specifically, the increase in the transistor 114 resistance (R_{DS(ON)}) decreases or limits the magnitude of inrush current that flows through the transistor 114 thereby dissipating energy in the transistor 114. In some examples, the energy dissipated is due to resistive losses.

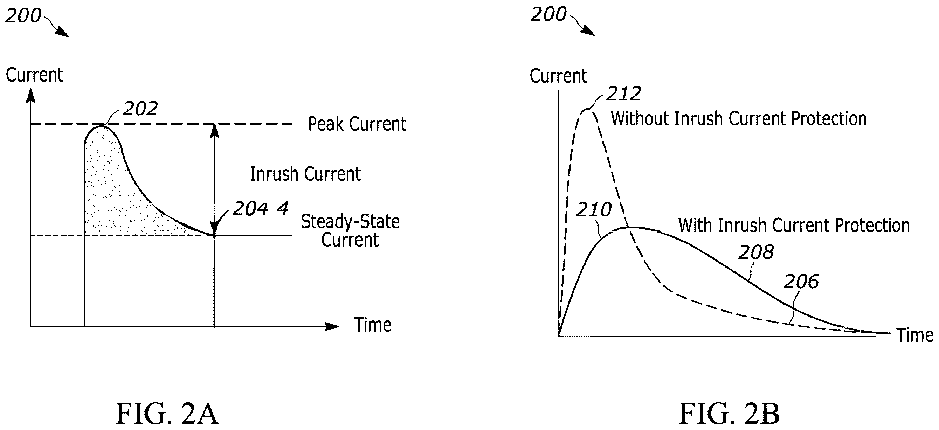

An effect of linear mode is shown in the graphs in FIG. 2A and 2B. In the graphs of FIG. 2A and 2B, the x-axis shows the time and the y-axis shows the magnitude of current. As shown in the graph 200 of FIG. 2A, there is an inrush of current reaching a peak current 202 and then the current reaches a steady-state current 204. As shown in the graph 200 of FIG. 2B, the line 206 represents the effect of the inrush current with inrush current protection (e.g., with linear mode) and the line 208 represents the effects of the inrush current without inrush current protection (e.g., without linear mode). The magnitude of inrushing current 210 with inrush current protection is less than the magnitude of inrushing current 212 without inrush current protection.

Referring back to FIG. 1, in some embodiments, the SSPC 100 further includes a hardware-based safe operating area unit 110. In some forms, the hardware-based safe operating area unit 110 may be a trip integrator with one or more capacitors and one or more resistors. The hardware-based safe operating area unit 110 monitors the power in the transistor 114, computes a temperature rise in the transistor, and sends a trip signal to the reference/off unit 109 to turn off the transistor 114 if the transistor temperature rises above a set threshold. The threshold is set so that the transistor 114 is turned off before the transistor 114 exceeds the operating area, such as the maximum power dissipation limit, to prevent thermal damage. As such, the transistor 114 may be prevented from operating outside the transistor specification. The combination of linear mode operation and hardware-based operating area operation ensures that the SSPC 100 can turn on successfully into high capacitive loads and ride out transients without nuisance trips.

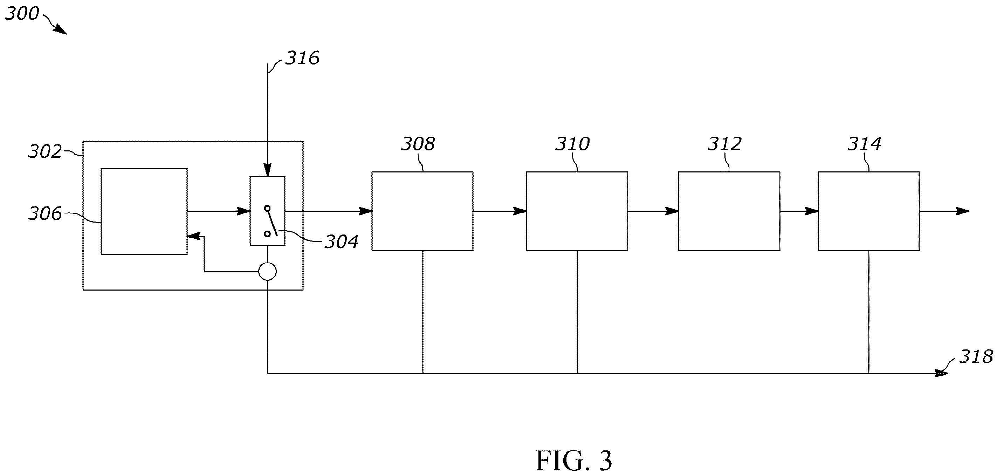

Referring to FIG. 3, a system 300 for modeling a temperature rise in a transistor is provided. The system 300 includes or a transistor cell 302 including a transistor 304 and a transistor control circuit 306, a measurement circuit 308, a power calculation circuit 310, a thermal modeling circuit 312, and a control circuit 314.

The transistor cell 302 is configured to be connected between an electrical source 316 and an electrical load 318. In particular, the transistor 304 includes a source side connected to the electrical source 316 and a load side connected to the electrical load 318. In one form, it is contemplated that the transistor cell 302 and the transistor 304 are for high voltage settings, such as, for example, in an aircraft electrical network with voltages in the range of about 28 volts DC (VDC) to about 270VDC or greater. In some embodiments, a solid state power controller (SSPC) may contain one or more of the exemplary transistor cell 302 shown in FIG. 3 for passing a current from the electrical source 316 to the electrical load 318.

The transistor 304 may comprise any of various types of transistors. In one preferred form, it is contemplated that a field effect transistor (FET) may be used, and in particular, a metal-oxide-semiconductor field-effect transistor (MOSFET). However, it should be understood that any of various types of transistors may be used, such as, for example, without limitation, a bipolar junction transistor (BJT), an insulated gate bipolar transistor (IGBT) or any other switching device.

The transistor control circuit 306 is operably coupled to the transistor 304 to control the transistor 304 gate voltage (e.g., a FET) or the base voltage (e.g., a BJT). For example, the transistor control circuit 306 may receive input, for example, from the control circuit 314 or other components external to the system 300 and output a gate drive signal to turn the transistor 304 on or off. In some forms, the transistor control circuit 306 is configured to operate the transistor 304 in linear mode as referenced and described in FIG. 1-2B above. The transistor control circuit 306 may comprise, for example, a gate driver or any suitable gate driver circuit.

The power calculation circuit 310 is connected to the measurement circuit 308 to calculate the power dissipated in the transistor 304 based on the voltage across the transistor 304 and the current passing through the transistor 304 measured by the measurement circuit 308. The power calculation circuit 310 comprises a multiplier to multiply the measured current and the measured voltage received from the measurement circuit 308 and generate a signal representing the power dissipated within the transistor 304.

The thermal modeling circuit 312 is connected to the power calculation circuit 310 to determine a die temperature rise in the transistor 304 based on the signal representing the power dissipation within the transistor 304. In other words, the thermal modeling circuit 312 models the operating area of the transistor 304. In some forms, the thermal modeling circuit 312 determines the die temperature rise in the transistor 304 over a predetermined period of time and outputs a signal indicative of the die temperature rise over the predetermined period to the control circuit 314.

Once the control circuit 314 detects a die temperature rise exceeding a predetermined threshold, the control circuit 314 triggers a predetermined action to protect the transistor 304 from thermal stress and/or prevent the transistor 304 from operating outside the transistor specification. In other words, the control circuit 314 triggers the predetermined action based on the modeled die temperature rise determined by the control circuit 314. The predetermined action may be in the form of transmitting a trip signal to turn off the transistor 304. The predetermined threshold may include a magnitude of the temperature rise in the range of about thirty (30) to about one hundred (100) degrees or a rate of change of the temperature rise over a predetermined length of time or, alternatively, for any amount of time.

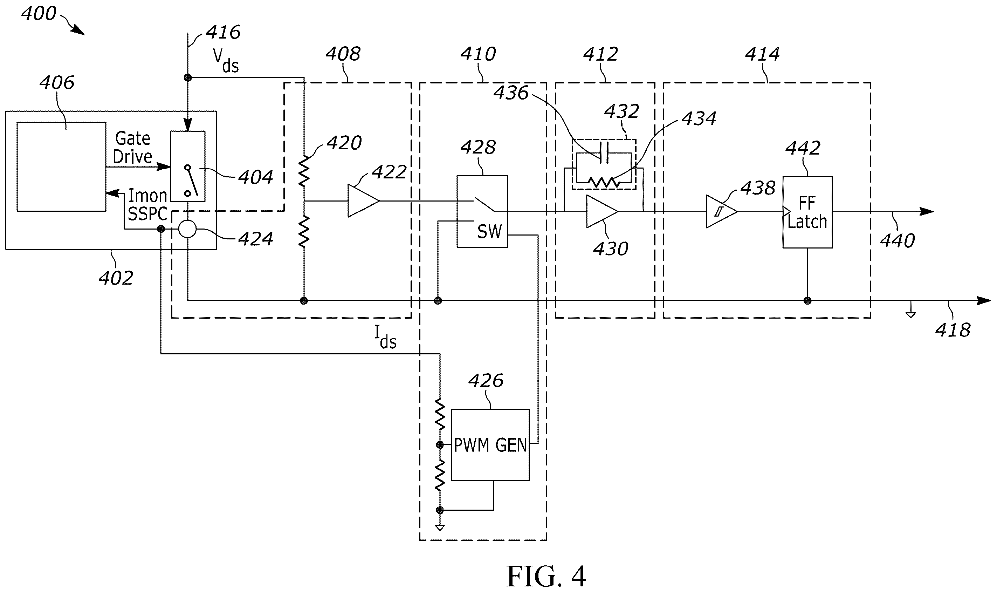

The control circuit 314 comprises, for example, a trip comparator (e.g., as shown in FIG. 4), or a digital controller or any other suitable processing device such as a microcontroller, a programmable logic device, a processor, a microprocessor, an application specific integrated circuit (ASIC), or a field-programmable gate array (FPGA).

The term control circuit refers broadly to any microcontroller, computer, or processor-based device with processor, memory, and programmable input/output peripherals, alone or in combination, which is generally designed to govern the operation of other components and devices (for example, the transistor control circuit 306, the transistor 304). It is further understood to include common accompanying accessory devices, including external memory, transceivers for communication with other components and devices, etc. The control circuit may be configured (for example, by using corresponding programming, instructions, and algorithms stored in a memory as will be well understood by those skilled in the art) to conduct one or more of the steps, actions, and/or functions described herein.

The control circuit may include a memory and a databus or network interface for accessing a wireless network(s). The memory can, for example, store non-transitorily computer instructions that cause the control circuit to operate as described herein, when the instructions are executed. Further, the network interface may enable the control circuit to communicate with other elements (both internal and external to the system). The network interface can communicatively couple the control circuit to the wireless network. The control circuit may make use of and/or operate in conjunction with databases. In some forms, the functionalities of the control circuit may be implemented on a plurality of processor devices, such as, for example, communicating with one another on a network.

It is contemplated that a response time of the measurement circuit 308, the power calculation circuit 310, the thermal modeling circuit 312, and the control circuit 314 is less than a predetermined threshold time such that the transistor 304 is not thermally stressed. In other words, the power dissipated in the transistor 304 and the die temperature rise in the transistor are calculated and modeled with sufficient speed, dynamic range and accuracy such that the temperature rise can be calculated fast enough as not to thermally stress the transistor 304.

Referring to FIG. 4, one example of a system 400 modelling a temperature rise within a transistor and protecting it from thermal stress or operating outside of the transistor specification is provided. The system 400 includes or has a transistor cell 402 including a transistor 404 and a transistor control circuit 406, a measurement circuits 408, a power calculation circuit 410, a thermal modeling circuit 412, and a control circuit 414. The transistor cell 402, and transistor 404 may be configured in substantially the same manner as described above in FIG. 3 and those descriptions will not be repeated here. Additionally, the measurement circuit 408, the power calculation circuit 410, the thermal modeling circuit 412, and the control circuit 414 may be an example of the a measurement circuit 308, a power calculation circuit 310, a thermal modeling circuit 312, and a control circuit 314 as shown in FIG. 3.

In the exemplary system 400 depicted in FIG. 4, the measurement circuit 408 includes one or more resistors 420, an amplifier 422 in series connection with the transistor 404 to measure the voltage across the transistor 404, and a current monitor 424 to measure the current flowing through the transistor 404. The one or more resistors 420 and amplifier 422 are connected to an input line of the electrical source 416 electrically upstream the transistor 404. The current monitor 424 is connected to an output line of the electrical load 418 electrically downstream the transistor 404. The current monitor 424 may include any suitable type of current monitor. In one form, the current monitor 424 may include a current sense resistor such as current sense resistor 116 shown in FIG. 1.

In some forms, to prevent the system 400 tripping over a long time, due to leakage or noise, a gating mechanism is employed in the current monitor 424. Specifically, the current monitor 424 is gated such that when the transistor 404 is in an open state (e.g., the transistor 404 is off and with no current flow), the current monitor 424 is disabled to ensure that zero current is detected by the power calculation circuit 410 during the open state periods. In this manner, the system 400 avoids false tripping caused by small leakage currents or noise, which could otherwise be misinterpreted as actual current flow.

The power calculation circuit 410 includes a pulse width modulation (PWM) generator 426 and an analogue switch 428 operatively coupled to the PWM generator 426. The PWM generator 426 is connected to the current monitor 424 to convert the measured current (I_{ds}) across the transistor 404 to a pulse width modulated signal (PWM) signal. The pulse width is proportional to the measured current (I_{ds}) and used an input to the analogue switch 428. The analogue switch 428, controlled by the PWM signal, gates the measured voltage signal (V_{ds}) in response to the PWM signal. The modulated output is a signal proportional to the instantaneous power dissipated in the transistor 404. It is contemplated that the power calculation circuit 410 outputs the signal proportional to the instantaneous power dissipated in the transistor 404 over a range of operating conditions of the transistor 404.

By eliminating the need for an analog multiplier, the power calculation circuit 410 is not limited by power rail constraints and dynamic range limitation. Advantageously, the power calculation circuit 410, and in particular, the PWM generator 426 and the analogue switch 428 provide an efficient and scalable solution for high voltage distribution to accurately monitor and control power dissipation in the transistor 404, ensuring reliable operation within the transistor specification.

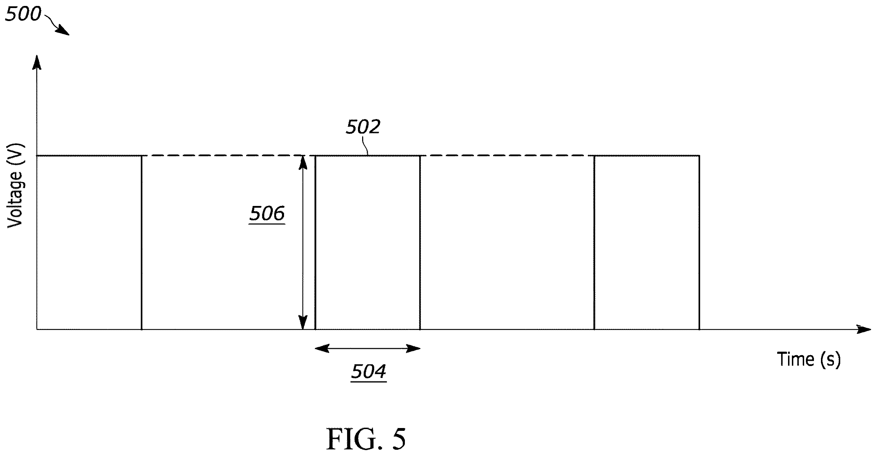

FIG. 5 shows a graph 500 of the output signal proportional to the instantaneous power of the transistor 404. The x-axis represents the time (e.g., in seconds) and the y axis represents the voltage (e.g., in volts). The PWM generator 426 produces the PWM signal with the pulse width proportional to the measured current (I_{ds}). The analogue switch 428 gates the measured voltage (V_{ds}) in response to the PWM signal to modulate the measured voltage (V_{ds}) with the PWM signal. The resulting signal (e.g., the output signal) is shown having a square waveform. Each pulse 502 includes a pulse width 504 proportional to the measured current (I_{ds}) in the transistor 404 and an amplitude 506 proportional to the measured voltage in the transistor 404. The area under the curve for each pulse 502 is proportional to the instantaneous power dissipated in the transistor 404 (P_{ds} = V_{ds} x I_{ds}).

Referring back to FIG. 4, the thermal modeling circuit 412 is connected to the power calculation circuit 410 for determining a die temperature rise in the transistor 404 based on the dissipated power. In particular, the thermal modeling circuit 412 includes an integrator 430 and an RC filter 432 connected to the PWM generator 426. The RC filter 432 includes, for example, a second-order RC filter or a third-order RC filter including one or more resistors 434 and one or more capacitors 436. The resistance and capacitance values of the RC filter 432 are representative of a thermal model of the transistor 404.

It is contemplated that if a different transistor is selected and employed, for example, due to obsolescence only the resistance and capacitance values of the RC filter 432 need to be changed to represent the thermal model of the respective transistor. As such, in some forms, the one or more resistors 434 and the one or more capacitors 436 comprise one or more variable resistors and one or more variable capacitors. The resistance and capacitance values of the variable resistors and variable capacitors may be varied by any suitable mechanical or electronic methods.

An output of the integrator 430 is connected to a comparator 438 of the control circuit 414. The comparator 438 compares the output signal generated by the integrator 430 representative of the die temperature rise in the transistor 404 to a predetermined threshold. As described above, the predetermined threshold may include a magnitude of the die temperature rise or a rate of change of the die temperature rise. In some aspects, the comparator 438 compares the die temperature rise in the transistor 404 to the predetermined threshold and outputs a trip signal 440 when the temperature rise exceeds the predetermined threshold for predetermined length of time or, alternatively, for any amount of time. The transistor control circuit 406 receives the trip signal 440 and outputs a gate drive signal to turn the transistor 404 off.

In some embodiments, the control circuit 414 further includes the comparator 438 and a digital storage device 442. The digital storage device 442 may comprise a latch mechanism, for example, a D (data or delay) latch, a flip flop (FF) latch or any suitable data storage device. The digital storage device 442 may receive a trip signal from the comparator 438 and output a latch trip signal (e.g., the trip signal 440) to the transistor control circuit 406 to turn off the transistor 404. The digital storage device 442 maintains a trip status (e.g., stores and hold the trip signal 440) of the transistor 404 until the digital storage device 442 receives a reset signal. In other words, the digital storage device 442 ensures the transistor 404 is turned off until the reset signal is received. The trip status (e.g., the trip signal 440) may be cleared by resetting the digital storage device 442 (e.g., a reset signal).

Additionally or alternatively, the transistor cell 402 is operated in linear mode as described above and referenced in FIGS. 1-2B, in combination with the operating area protection (e.g., the measurement circuit 408, the power calculation circuit 410, the thermal modeling circuit 412, the control circuit 414). The transistor cell 402 may operate simultaneously in linear mode and operating area protection mode with each mode triggered by different conditions. In other words, the linear mode manages the immediate current surge, while the operating area protection ensures that the overall power dissipation remains within the defined limits under which the transistor can operate, preventing long-term damage. In this manner, the linear mode is controlled (e.g., activated) by the transistor cell control circuit 406 to manage inrush currents and transients during specific events such as power-up or transient conditions. The operating area protection mode is continuously active to monitor the power dissipation in the transistor 404 and ensure the transistor 404 operates within the transistor specification, thus providing continuous protection against thermal damage and other forms of stress to the transistor 404. It is contemplated that the combination of linear mode and the operating area protection ensures that the transistor 404 can turn on successfully into high capacitive loads and ride out transients without nuisance trips.

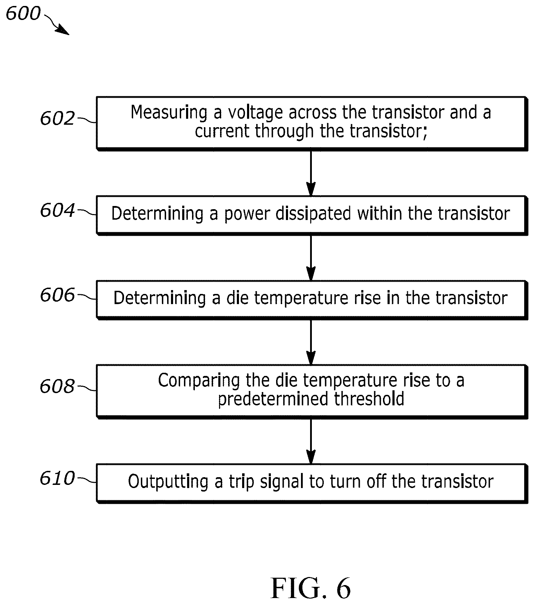

Referring to FIG. 6, a flow chart illustrating an exemplary method 600 for modeling a die temperature rise in a transistor in accordance with various embodiments is provided. The method 600 may use some of all of the components described in connection with the systems described and referenced FIGS. 1-5. The above description of these systems is incorporated herein.

In block 602, a voltage across a transistor and a current through the transistor is measured. In block 604, a power dissipated in the transistor is determined by multiplying the measured voltage and the measured current. In one form, it is contemplated that a PWM generator and an analogue switch may be used. The PWM generator produces a pulse width signal proportional to the measured current and the analogue switch gates a signal proportional to the measured voltage in response to the pulse width signal to determine the power dissipated in the transistor.

In block 606, the die temperature rise in the transistor is determined based on the power dissipated within the transistor. In block 608, the die temperature rise is compared to a predetermined threshold. If the determined die temperature rise in the transistor exceeds the predetermined threshold, in block 610, a trip signal to turn off the transistor is output. The trip signal is provided to a cell control unit and the cell control unit outputs a gate drive signal to turn the transistor on or off.

In some embodiments, the transistor may be operated in linear mode in parallel with the above described method 600. As described above, the linear mode manages inrush current and protects the transistor from high capacitive loads or other transients, such as lightning to avoid nuisance tripping. For example, in normal operation, a gate voltage (V_{GS}) of the transistor is increased to minimize a resistance (R_{DS(ON)}) of the transistor. Upon detection of a transient event, a gate voltage (V_{GS}) of the transistor is decreased to increase a resistance (R_{DS(ON)}) if the transistor. The increase in the resistance (R_{DS(ON)}) of the transistor manages inrush but dissipates energy in the transistor. As described above in block 602-610, the method 600 will monitor the power dissipated (e.g., dissipated energy) and turn off the transistor to ensure that the overall power dissipation remains within the defined limits, preventing long-term damage to the transistor.

Further aspects of the disclosure are provided by the subject matter of the following clauses:
A system for modelling a temperature rise within a transistor, the system comprising: a measurement circuit configured to measure a voltage across the transistor and a current passing through the transistor; a power calculation circuit communicatively coupled to the measurement circuit configured to multiply the measured current and the measured voltage to generate a signal representing a power dissipated within the transistor; a thermal modeling circuit communicatively coupled to the power calculation circuit and configured to generate an output signal indicative of a die temperature rise in the transistor over a predetermined period; and a control circuit communicatively coupled to the thermal modeling circuit and configured to compare the die temperature rise to a predetermined threshold, and in response to determining that the die temperature rise is greater than the predetermined threshold, output a trip signal to turn off the transistor.

A system for modelling a temperature rise within a transistor, the system comprising: a measurement circuit configured to measure a voltage across the transistor and a current passing through the transistor; a power calculation circuit communicatively coupled to the measurement circuit, the power calculation circuit configured to multiply the measured current and the measured voltage to generate a signal representing a power dissipated within the transistor; a thermal modeling circuit communicatively coupled to the power calculation circuit and configured to generate an output signal indicative of a die temperature rise in the transistor over a predetermined period; and a control circuit communicatively coupled to the thermal modeling circuit and configured to compare the die temperature rise to a predetermined threshold, and in response to determining that the die temperature rise is greater than the predetermined threshold, output a trip signal to turn off the transistor.

The system of any preceding clause, wherein the measurement circuit is electrically coupled to the transistor.

The system of any preceding clause, wherein the transistor includes a metal-oxide-semiconductor field-effect transistor (MOSFET), a bipolar junction transistor (BJT) or an insulated gate bipolar transistor (IGBT).

The system of any preceding clause, wherein the power calculation circuit is configured to compute the signal representing the power dissipation within the transistor within a predetermined time period to protect the transistor from thermal stress.

The system of any preceding clause, wherein the power calculation circuit includes a pulse width modulation (PWM) generator and an analogue switch operatively coupled to the PWM generator.

The system of any preceding clause, wherein the PWM generator is configured to produce a pulse width signal proportional to the measured current and the analogue switch gates a signal proportional to the measured voltage in response to the pulse width signal to generate the signal representing the power dissipated in the transistor.

The system of any preceding clause, wherein a response time of the measurement circuit, the power calculation circuit, the thermal modeling circuit, and the control circuit is less than a predetermined threshold time such that the transistor is not thermally stressed.

The system of any preceding clause, wherein the power calculation circuit configured to multiply the measured current and the measured voltage to generate the signal representing the power dissipated within the transistor over a range of operating conditions of the transistor.

The system of any preceding clause, wherein the thermal modeling circuit includes a RC filter.

The system of any preceding clause, wherein the RC filter comprises a second-order RC filter or a third-order RC filter.

The system of any preceding clause, wherein the thermal modeling circuit includes an integrator, one or more resistors and one or more capacitors representative of a thermal model of the transistor.

The system of any preceding clause, wherein the one or more resistors and the one or more capacitors comprise one or more variable resistors and one or more variable capacitors.

The system of any preceding clause, wherein the control circuit includes a comparator configured to compare the die temperature rise to the predetermined threshold and output the trip signal to turn off the transistor when the die temperature rise is greater than the predetermined threshold.

The system of any preceding clause, wherein the control circuit includes a comparator configured to compare the die temperature rise to the predetermined threshold and output the trip signal to turn off the transistor when the die temperature rise is greater than the predetermined threshold for a predetermined length of time.

The system of any preceding clause, wherein the control circuit includes a comparator and a latch connected to the comparator.

The system of any preceding clause, wherein the comparator is configured compare the die temperature rise to the predetermined threshold and output a trip signal when the die temperature rise is greater than the predetermined threshold; and wherein the latch is configured to receive the trip signal and output a latched trip signal to turn off the transistor.

The system of any preceding clause, wherein the latch is configured to maintain the trip signal to turn off the transistor until the latch receives a reset signal.

The system of any preceding clause, wherein the transistor is connected to a transistor control circuit configured to control the transistor voltage.

The system of any preceding clause, wherein the transistor is connected to a transistor control circuit configured to control a voltage of the transistor.

The system of any preceding clause, wherein the transistor is a MOSFET and wherein the transistor control circuit is configured to increase or decrease a gate voltage of the MOSFET in linear mode operation to limit inrush current such that energy is dissipated in the MOSFET.

A method for modeling a temperature rise within a transistor, the method comprising: measuring a voltage across the transistor and a current through the transistor; multiplying the measured voltage and the current to determine a power dissipated within the transistor; determining a die temperature rise in the transistor based on the power dissipated within the transistor; comparing the die temperature rise to a predetermined threshold; and outputting a trip signal to turn off the transistor when the die temperature rise is greater than the predetermined threshold.

## Claims

1. A system (400) for modelling a temperature rise within a transistor (404), the system comprising:
a measurement circuit (408) configured to measure a voltage (V_{ds}) across the transistor (404) and a current (I_{ds}) passing through the transistor (404);
a power calculation circuit (410) communicatively coupled to the measurement circuit, the power calculation circuit configured to multiply the measured current (I_{ds}) and the measured voltage (V_{ds}) to generate a signal representing a power dissipated within the transistor (404);
a thermal modeling circuit (412) communicatively coupled to the power calculation circuit (410) and configured to generate an output signal indicative of a die temperature rise in the transistor (404) over a predetermined period; and
a control circuit (414) communicatively coupled to the thermal modeling circuit (412) and configured to compare the die temperature rise to a predetermined threshold, and in response to determining that the die temperature rise is greater than the predetermined threshold, output a trip signal (440) to turn off the transistor (404).

2. The system of claim 1, wherein the measurement circuit (408) is electrically coupled to the transistor (404).

3. The system of any preceding claim, wherein the transistor (404) includes a metal-oxide-semiconductor field-effect transistor (MOSFET), a bipolar junction transistor (BJT) or an insulated gate bipolar transistor (IGBT).

4. The system of any preceding claim, wherein the power calculation circuit (410) is configured to compute the signal representing the power dissipation within the transistor (404) within a predetermined time period to protect the transistor (404) from thermal stress.

5. The system of any preceding claim, wherein the power calculation circuit (410) includes a pulse width modulation (PWM) generator (426) and an analogue switch (428) operatively coupled to the PWM generator (426).

6. The system of claim 5, wherein the PWM generator (426) is configured to produce a pulse width signal proportional to the measured current (I_{ds}) and the analogue switch (428) gates a signal proportional to the measured voltage (V_{ds}) in response to the pulse width signal to generate the signal representing the power dissipated in the transistor (404).

7. The system of any preceding claim, wherein a response time of the measurement circuit (408), the power calculation circuit (410), the thermal modeling circuit (412), and the control circuit (414)is less than a predetermined threshold time such that the transistor (404) is not thermally stressed.

8. The system of any preceding claim, wherein the power calculation circuit (410) is configured to multiply the measured current (I_{ds}) and the measured voltage (V_{ds}) to generate the signal representing the power dissipated within the transistor (404) over a range of operating conditions of the transistor (404).

9. The system of any preceding claim, wherein the thermal modeling circuit (412) includes a RC filter (432).

10. The system of any preceding claim, wherein the thermal modeling circuit (412) includes an integrator (430), one or more resistors (434) and one or more capacitors (436) representative of a thermal model of the transistor (404).

11. The system of any preceding claim, wherein the control circuit (414) includes a comparator (438) configured to compare the die temperature rise to the predetermined threshold and output the trip signal (440) to turn off the transistor (404) when the die temperature rise is greater than the predetermined threshold.

12. The system of any preceding claim, wherein the control circuit (414) includes a comparator (438) configured compare the die temperature rise to the predetermined threshold and output a trip signal (440) when the die temperature rise is greater than the predetermined threshold and a latch (442) connected to the comparator (438) configured to receive the trip signal and output a latched trip signal to turn off the transistor (404).

13. The system of any preceding claim, wherein the transistor (404) is connected to a transistor control circuit (406) configured to control a voltage of the transistor (404).

14. The system of claim 13, wherein the transistor (404) is a MOSFET and wherein the transistor control circuit (406) is configured to increase or decrease a gate voltage of the MOSFET in linear mode operation to limit inrush current such that energy is dissipated in the MOSFET.

15. A method (600) for modeling a temperature rise within a transistor, the method comprising:
measuring (602) a voltage across the transistor and a current through the transistor;
multiplying (604) the measured voltage and the current to determine a power dissipated within the transistor;
determining (606) a die temperature rise in the transistor based on the power dissipated within the transistor;
comparing (608) the die temperature rise to a predetermined threshold;
outputting (610) a trip signal to turn off the transistor when the die temperature rise is greater than the predetermined threshold.
